# EUROPEAN PATENT APPLICATION

(11) **EP 4 546 628 A1**
(43) Date of publication of application: **30.04.2025**
(21) Application number: 23205527.7
(22) Date of filing: 24.10.2023
(51) Int. Cl.: H02M 1/00, H02M 3/335

(54) **ADAPTIVE SLEW RATE DETECTION FOR A SYNCHRONOUS RECTIFIER OF A SYNCHRONOUS FLYBACK CONVERTER**

(71) Applicant: Nexperia B.V., 6534 AB Nijmegen (NL); Nexperia Technology (Shanghai) Ltd., Shanghai 200025 (CN)
(72) Inventor: Jin, GaoXian, Shanghai (CN); Wang, Minhua, Shanghai (CN); Huang, Long, Shenzhen (CN); Zeng, Wanhua, Shenzhen (CZ); Xie, Minyi, Shenzhen (CN); Shen, Feifei, Shenzhen (CN)
(74) Representative: Pjanovic, Ilija

(57) **Abstract**

A controller of a synchronous rectifier of a synchronous flyback converter is presented. The synchronous rectifier includes a switch that is switchable by the controller. The controller includes an adaptive slew rate detection circuit that is configured to add a current to a base slew rate current depending on an off-time of the switch to obtain a slew rate current. The slew rate current determines a slew rate setting voltage. The controller is configured to turn on the switch of the synchronous rectifier depending on the slew rate setting voltage.

## Description

### Technical field

The present disclosure relates to a controller of a synchronous rectifier, a synchronous flyback converter including such controller, and a switching power supply including such synchronous flyback converter.

### Background

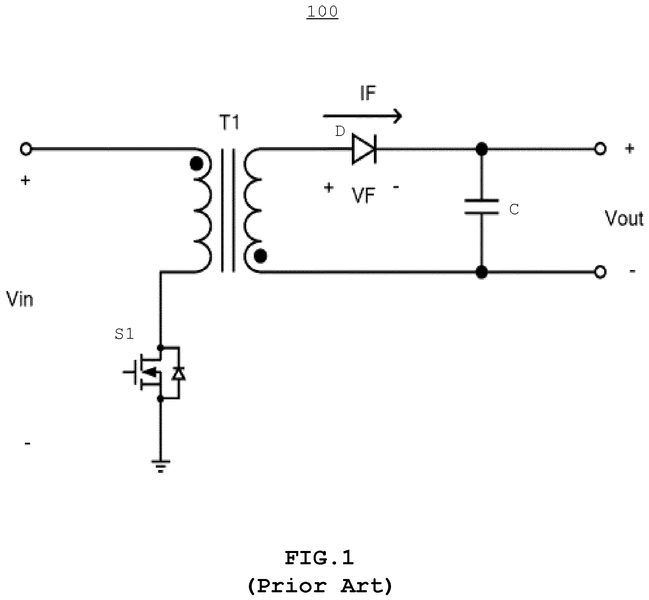

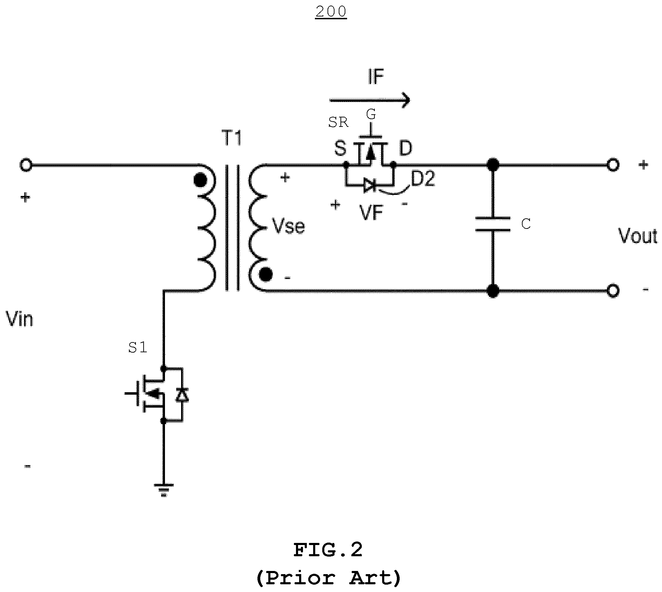

Fig. 1 and Fig. 2 show two examples of known rectifying schemes that can be used in a secondary side of isolated switching converters. Fig. 1 shows a rectifying scheme 100 for non-synchronous rectifying using a diode D and Fig. 2 shows a rectifying scheme 200 for synchronous rectifying using a synchronous rectifier SR, e.g., an n-channel metal-oxide-semiconductor field-effect transistor (N-MOSFET) or more generally any synchronous rectifier FET in combination with a body diode D2. The rectifying schemes 100, 200 typically include a transformer T1, with a primary switch S1 driving the primary winding of the transformer T1. The diode D and the synchronous rectifier SR are connected to the secondary winding of the transformer T1. Further shown are a capacitor C and indicators for an input voltage Vin, an output voltage Vout, a secondary voltage Vse, a forward voltage VF, a forward current IF, a source S at SR, a drain D at SR, and a control signal G at SR.

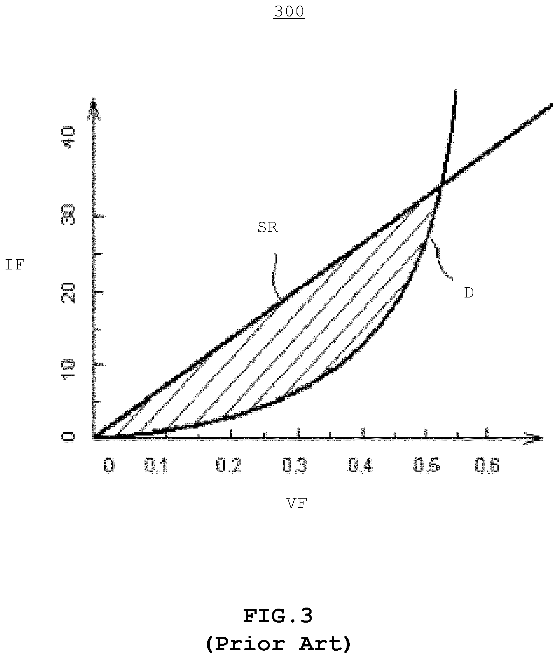

In Fig. 3, example power dissipation-current characteristics 300 for the diode D of Fig. 1 and the synchronous rectifier SR of Fig. 2 are plotted. Compared to the relatively fixed forward voltage drop of the diode, the synchronous rectifier FET's voltage drop is proportional to the current and turn-on resistance. A synchronous rectifier solution can therefore achieve better efficiency and thermal performance than a conventional diode solution, which is, e.g., an important requirement for high-power adapter designs.

Synchronous rectifiers have thus found increasingly wide applications in devices sensitive to power efficiency, such as laptop adapters, wireless equipment, LCD power management modules, power over Ethernet, and so on.

The synchronous rectifying scheme, such as shown in Fig. 2, may be used in a synchronous flyback converter. A flyback converter is a type of switching power supply topology commonly used for applications such as power adapters, battery chargers, and voltage converters, and operates by storing energy in a transformer during the switch-on time and then releasing it to the output during the switch-off time.

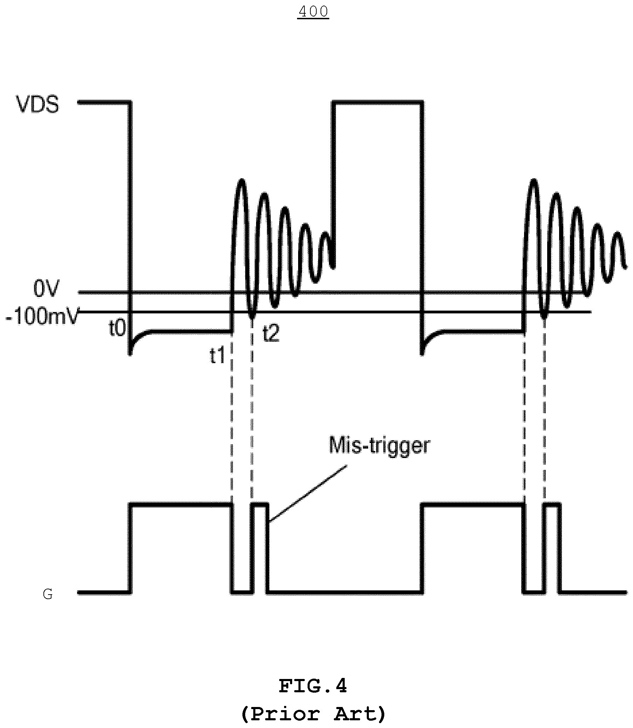

Fig. 4 schematically shows example waveforms 400 of a drain-source voltage VDS and a control signal G of a synchronous rectifier, e.g., the synchronous rectifier SR of Fig.2, in a synchronous flyback converter under discontinuous current mode (DCM). The drain-source voltage VDS may also be referred as a switch voltage or a voltage across the synchronous rectifier SR. Normally, when a primary switch S1 coupled to the primary winding of transformer T1 is turned on, the input voltage Vin as shown in Fig. 2 is configured to the dotted terminal of the primary winding. Then, the dotted terminal of the secondary winding is positive and the drain-source voltage VDS is positive too. As a result, the body diode D2 of the synchronous rectifier SR is reverse biased. At time t0, the primary switch S1 is turned off, energy stored in the primary winding is transferred to the secondary winding of the transformer T1. A current flowing through the secondary winding from the dotted terminal gets the body diode D2 forward biased. As a result, the drain-source voltage VDS=-VF decreases to a negative value, wherein VF is a forward voltage drop of the body diode D2 of the synchronous rectifier SR. In some applications, on and off of the synchronous rectifier SR may be determined by a comparison result of the drain-source voltage VDS with a preset threshold, wherein the comparison result is reflected by the control signal G. In this example, when the drain-source voltage VDS of the synchronous rectifier SR decreases to a first preset value, e.g., -100 mV, the synchronous rectifier SR is turned on by the secondary control signal G, and when the drain-source voltage VDS of the synchronous rectifier SR increases to a second preset value, e.g., 0V, the synchronous rectifier is turned off by the secondary control signal G. As can be seen from Fig. 4, the synchronous rectifier SR is supposed to be turned off after time t1 when the drain-source voltage VDS increases to 0V. But when the flyback converter works under DCM in real application, the drain-source voltage VDS may ring (i.e., experience oscillatory behavior) after the synchronous rectifier SR is turned off and, in this example, rings down to -100 mVat time t2. As a result, the synchronous rectifier SR is unexpectedly turned on (mis-triggered) by the secondary control signal G at time t2.

### Summary

A summary of aspects of certain examples disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

The present disclosure aims to overcome the drawbacks identified in the background section. In particular, the present disclosure aims to prevent misstriggering as a result of DCM ringing in a synchronous rectifier at a second side of a transformer in a synchronous flyback converter.

The present disclosure presents a solution to prevent a synchronous rectifier from mis-triggering during DCM ringing. Advantageously, the synchronous rectifier of the present disclosure may be conducted under all load conditions (i.e., heavy load and light load).

According to an aspect of the present disclosure, a controller of a synchronous rectifier is presented. The synchronous rectifier may include a switch that is switchable by the controller. The controller may include an adaptive slew rate detection circuit. The adaptive slew rate detection circuit may be configured to add a current to a base slew rate current depending on an off-time of the switch to obtain a slew rate current. The slew rate current may determine a slew rate setting voltage. The controller may be configured to turn on the switch depending on the slew rate setting voltage.

In an embodiment, the controller may further include a gate state detection circuit configured to detect an off-state of the switch. The adaptive slew rate detection circuit may be configured to add the current to the base slew rate current when the switch is in the off-state.

In an embodiment, the adaptive slew rate detection circuit may include a plurality of current selectors. Each current selector may be configured to detect different off-times of the switch based on a voltage generated as a result of charging characteristics of a capacitor during the off-time of the switch. Each current selector may be configured to include a different current source to the adaptive slew rate detection circuit to add a respective current to the base slew rate current.

In an embodiment, each current selector may be configured to switch a current switch to include the respective current source into the slew rate detection circuit.

In another embodiment, the adaptive slew rate detection circuit may include a current selector. The current selector may be configured to increasingly add the current depending on the off-time of the switch based on a voltage generated as a result of charging characteristics of a capacitor during the off-time of the switch.

In an embodiment, the synchronous rectifier may be configured to operate in a discontinuous current mode.

In an embodiment, the switch may include a field-effect transistor.

According to an aspect of the present disclosure, a synchronous flyback converter is presented. The synchronous flyback converter may include a transformer. The synchronous flyback converter may include a primary switch coupled to a primary winding of the transformer. The synchronous flyback converter may include a synchronous rectifier coupled to a secondary winding of the transformer. The synchronous rectifier may include a secondary switch that is switchable under control of a controller having one or more of the above-described features.

According to an aspect of the present disclosure, a switching power supply is presented. The switching power supply may include a synchronous flyback converter having one or more of the above-described features.

### Brief description of the Drawings

Embodiments of the present disclosure will now be described, by way of example only, with reference to the accompanying schematic drawings in which corresponding reference symbol indicate corresponding parts, in which:
Fig. 1 shows a known rectifying scheme for non-synchronous rectifying using a diode D;
Fig. 2 shows a known rectifying scheme for synchronous rectifying using a synchronous rectifier;
Fig. 3 shows an example current-voltage characteristic of switching converters with a non-synchronous rectifier as in Fig. 1 and a synchronous rectifier as in Fig. 2;
Fig. 4 schematically shows waveforms of a drain-source voltage and a control signal of a known synchronous rectifier of a synchronous flyback converter under DCM;
Fig. 5 schematically shows an example synchronous rectifying scheme of an example flyback converter;
Fig. 6 show example graphs of various voltage characteristics of the synchronous rectifying scheme of Fig. 5;
Fig. 7 schematically shows a secondary controller of an example embodiment of the present disclosure;
Fig. 8 and Fig. 10 schematically show different implementations of dynamic slew rate detection circuits of a secondary controller of exemplary embodiments of the present disclosure; and
Fig. 9 and Fig. 11 show example graphs of voltage and current characteristics of the dynamic slew rate detection circuits of Fig. 8 and Fig. 10, respectively.

The figures are intended for illustrative purposes only, and do not serve as restriction of the scope of the protection as laid down by the claims.

### Detailed description

It will be readily understood that the components of the embodiments as generally described herein and illustrated in the appended figures could be arranged and designed in a wide variety of different configurations. Thus, the following more detailed description of various embodiments, as represented in the figures, is not intended to limit the scope of the present disclosure but is merely representative of various embodiments. While the various aspects of the embodiments are presented in drawings, the drawings are not necessarily drawn to scale unless specifically indicated.

The described embodiments are to be considered in all respects only as illustrative and not restrictive. The scope of the present disclosure is, therefore, indicated by the appended claims rather than by this detailed description. All changes which come within the meaning and range of equivalency of the claims are to be embraced within their scope.

Reference throughout this specification to features, advantages, or similar language does not imply that all of the features and advantages that may be realized with the present disclosure should be or are in any single example of the present disclosure. Rather, language referring to the features and advantages is understood to mean that a specific feature, advantage, or characteristic described in connection with an embodiment is included in at least one embodiment of the present disclosure. Thus, discussions of the features and advantages, and similar language, throughout this specification may, but do not necessarily, refer to the same example.

Furthermore, the described features, advantages, and characteristics of the present disclosure may be combined in any suitable manner in one or more embodiments. One skilled in the relevant art will recognize, in light of the description herein, that the present disclosure may be practiced without one or more of the specific features or advantages of a particular embodiment. In other instances, additional features and advantages may be recognized in certain embodiments that may not be present in all embodiments of the present disclosure. Reference throughout this specification to "one embodiment," "an embodiment," or similar language means that a particular feature, structure, or characteristic described in connection with the indicated embodiment is included in at least one embodiment of the present disclosure. Thus, the phrases "in one embodiment," "in an embodiment," and similar language throughout this specification may, but do not necessarily, all refer to the same embodiment.

In the following example embodiments, numerous specific details are provided, such as examples of circuits, components, and methods, to provide a thorough understanding of embodiments of the technology. Persons of ordinary skill in the art will recognize, however, that the technology can be practiced without one or more of the specific details. In other instances, well-known details are not shown or described to avoid obscuring aspects of the technology.

In the context of flyback topology and power electronics, the term "slew rate" typically refers to the rate of change of voltage or current in the circuit.

The present disclosure presents an adaptive slew rate detection method for synchronous rectification, where the slew rate may be set differently based on the length of the switch off time of the synchronous rectifier at the second side of a transformer. The shorter the off time, the higher the slew rate, which may advantageously prevent the switch (i.e., of the synchronous rectifier) from being mis-triggered during a DCM ringing process. At the same time, the solution of the present disclosure ensures more reliable conduction of switch tube under light load condition, and thus improves light load efficiency.

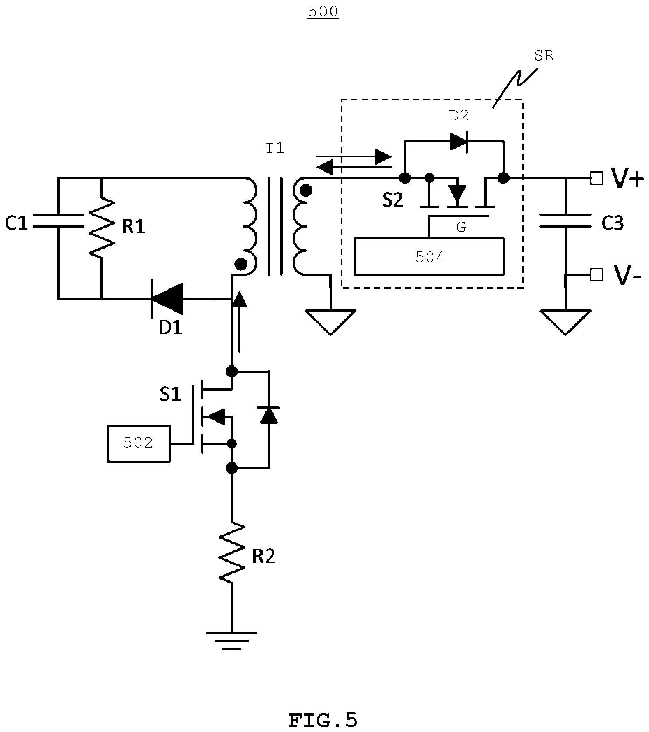

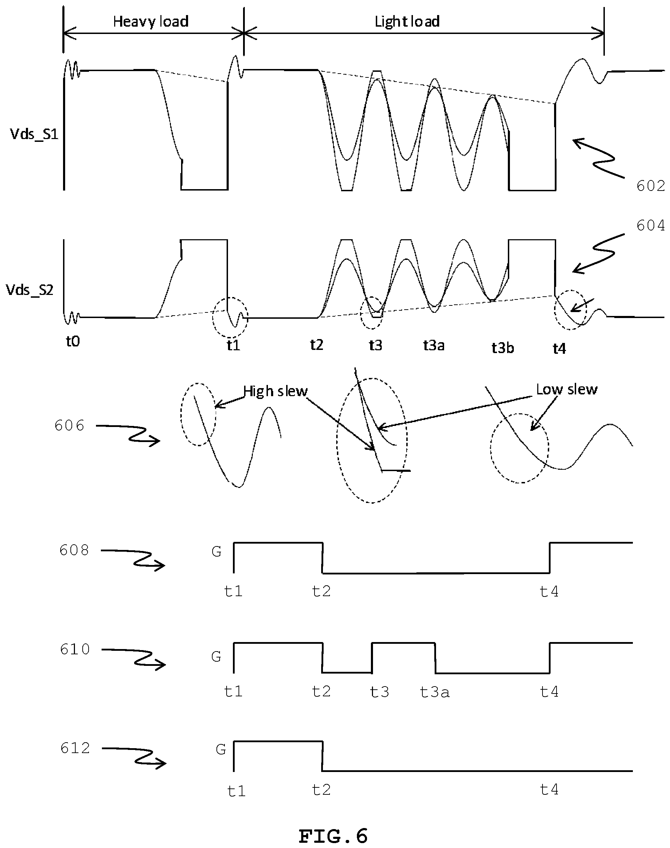

To better understand the concept of slew rate and mis-triggering, an example of a synchronous rectifying scheme 500 of a flyback converter and example voltage characteristics of this rectifying scheme are shown in Fig. 5 and Fig. 6, respectively. The rectifying scheme of Fig. 5 is similar to the rectifying scheme of Fig. 2, with the addition of switch controllers 502 and 504, and an energy storing circuit including a diode D1, a resistor R1 and a capacitor C1 at the primary side of the transformer T1.

The synchronous rectifier scheme 500 includes a transformer T1. A primary switch S1 may be coupled to the primary winding of transformer T1. A primary switch S1, e.g., a FET, may be switched on and off under control of primary controller 502. The primary switch S1 may further be coupled to the energy storing circuit. A synchronous rectifier SR may be coupled to the secondary winding of the transformer T1. A secondary switch S2, e.g., a FET, of the synchronous rectifier SR may be switched on and off via its gate G under control of secondary controller 504. Fig. 5 further shows a resistor R2, a capacitor C3 and output voltage pins V+ and V-.

The primary controller 502 and the secondary controller 504 may be connected to the gate of the primary switch S1 and the gate G of the secondary switch S2, respectively, to control the on and off states of the switches S1 and S2. In the example of Fig. 5, the secondary controller 504 may be preconfigured to detect specific slew rates in the drain-source voltage Vds_S2 of the secondary switch S2, which slew rates may trigger the secondary controller 504 to switch the switch S2.

In Fig. 6, the drain-source voltage Vds_S1 of the first switch S1 and the drain-source voltage Vds_S2 of the second switch S2 are plotted in time as lines 602 and 604. In this example, between t0 and t1 the system is under heavy load and between t1 and t4 the system in under light load. Parts of the graph 604 of Vds_S2 in the dotted circles at t1, t3 and t4 are shown zoomed-in below the graph as zoomed-in sections 606.

In the example of Fig. 6, under normal operation, from time t1 to t2 the primary switch S1 may turn on at t1. The high slew rate in Vds_S2 may then trigger the secondary controller 504 to turn on the secondary switch S2 of the synchronous rectifier SR, which is illustrated by graph 608 where the control signal at the gate G of the secondary switch S2 becomes high at t1. Under normal operation, as long as Vds_S2 is at 0V, the control signal at gate G should remain high, thereby keeping the synchronous rectifier SR in the on state. At time t2, the transformer T1 may be demagnetized and, Vds_S2 starts rising because of declining Vds_S1 and as a result the secondary switch S2 may be turned off. The secondary switch S2 may be kept off during the DCM ringing period between t2 and t3b, when the voltage declined slew rate is slower than the slew setting of the secondary controller 504. In the example of Fig. 6, at time t3b the Vds_S2 signal 604 stabilizes (the DCM ringing stops) and the secondary switch S2 is kept in the off state. At time t4 a low slew rate may be detected by the secondary controller 504, triggering the control signal at the gate G to become high, thereby turning on the secondary switch S2.

In known secondary controllers 504, the slew rate settings triggering the control signals at the gate G of the secondary switch S2 have fixed values. Under the light load condition, the amplitude of the DCM ringing in Vds_S1 caused, e.g., by magnetic inductance and output capacitance (Coss) of the primary switch S1 may increase significantly after the secondary switch S2 turns off, in the example of Fig, 6 at t2, which may result in Vds_S2 also becoming strongly resonant. As a result, the waveform of Vds_S2 may change from the original sine wave to an approximate trapezoidal wave, which is shown in graph 604 as the second, clipped line on top of the sine waveform. In the example of Fig. 6, as a result, the slope of Vds_S2 at the time of zero-crossing t3 may significantly increase, which is illustrated in zoomed-in graph 606 by the high slew below the low slew at t3.

If the detected slew rate is faster than the internal setting of the secondary controller 504, the high slew at t3 may mis-trigger the secondary controller 504, resulting in the secondary switch S2 being incorrectly switched. This is illustrated in graph 610, where the gate signal at the gate G becomes high at t3, where it should remain low as illustrated in graph 608.

Another example of mis-triggering may occur at t4. Leakage inductance and Coss of the primary switch S1 may resonate when S1 is turned off at t1. The slew rate of Vds_S2 at t4 (under light load) may be much lower than the slew rate of Vds_S2 at t1 (under heavy load). As a result, the secondary switch S2 may not be triggered if the detected slew rate is slower than the internal setting of the secondary controller 504. This is illustrated in graph 612, where the gate signal G remains low at t4, where it should become high as illustrated in graph 608.

If the setting slew rate is too fast, the secondary switch S2 may not be mis-triggered during DCM ringing, but the secondary switch S2 typically can't be conducted under most of the load conditions. On the other hand, if the setting slew rate is too low, the secondary switch S2 may be conducted even at light load but may be mis-triggered during the DCM ringing. As a result, with fixed slew rate setting it can be difficult to turn on the secondary switch S2 correctly while at the same time preventing the secondary switch S2 from being mis-triggered during DCM ringing.

The present disclosure presents a solution to the above identified drawbacks of known synchronous flyback converters, and in particular presents an adaptive slew rate setting/detection at the secondary controller of the synchronous rectifier SR. Hereto, the secondary controller 504 may be adapted to detect a time off period of the secondary switch S2 and adapt the slew rate setting accordingly. E.g., the longer the secondary switch S2 is off (the control signal at the gate G may then be low), the lower the slew rate setting. In the example of Fig. 6, the slew rate setting at t4 may be dynamically set lower than the slew rate setting at t3b, which may be dynamically set lower than the slew rate setting at t3a, which may be dynamically set lower than the slew rate setting at t3. In this example, the slew rate setting at t3 may thus be fastest, so to prevent the secondary switch S2 from mis-triggering during DCM ringing. In this example, the slew rate setting at t4 may thus be slowest, so the secondary switch S2 may be conducted even under light load condition.

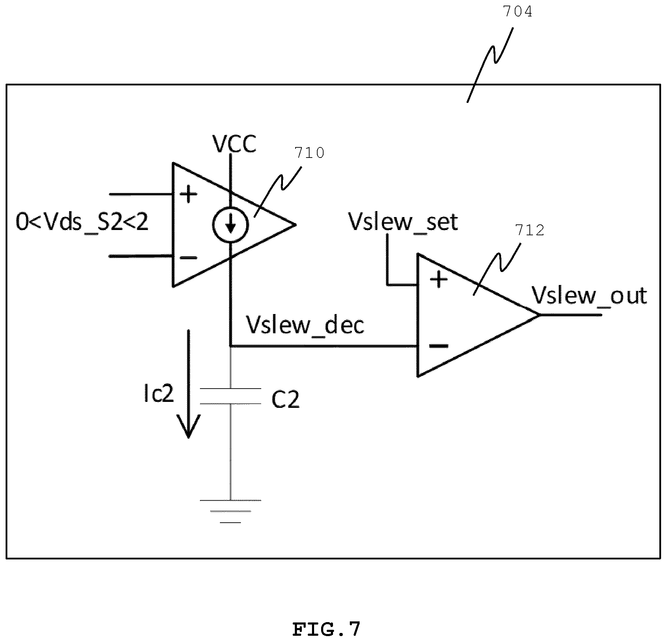

Fig. 7 shows an example embodiment of an improved secondary controller 704, which may replace the secondary controller 504 of Fig. 5. Only parts of the controller 704 involved in the adaptive slew rate setting and detection are shown in Fig. 7. Other not-shown parts may be implemented in a manner known per-se, e.g., similar to any known secondary controller.

In Fig. 7, a detector 710, e.g., implemented using a comparator, may detect a current slew rate in the Vds_S2 signal. Output of the detector 710 may be a voltage indicative of the degree of decrementing of the Vds_S2, in Fig. 7 depicted as Vslew_dec, thus indicative of the detected slew rate. Note that in the example of Fig. 7 a capacitor C2 induces a current Ic2.

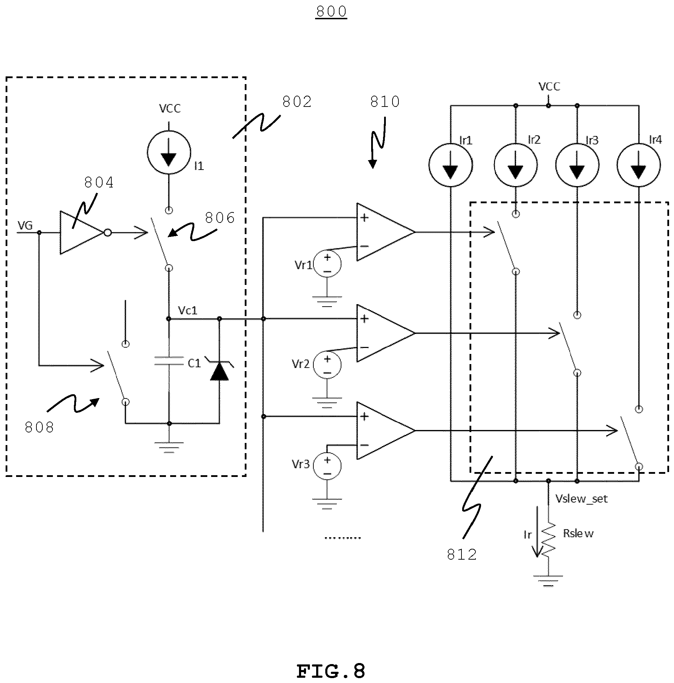

The detected slew rate Vslew_dec may be compared with an adaptive slew rate setting Vslew_set by a comparator 712, which adaptive slew rate setting Vslew_set may be determined be an adaptive slew rate circuit, examples of which will be explained with Figs. 8-11. In the example of Fig. 7, the detected slew rate Vslew_dec may be input to the negative input of the comparator 712 and the adaptive slew rate setting Vslew_set may be input to the positive input of the comparator 712. Output of the comparator 712 is a trigger signal Vslew_out that may be or may be used to generate the control signal that triggers the switching of the gate G of the secondary switch S2.

Fig. 7 is to be understood as a non-limiting example. Other components or configurations may be used instead of the detector 710, i.e., detection of the current slew rate in the Vds_S2 signal may be performed in any manner known per-se, e.g., as performed by a known secondary controller 504 using fixed slew rate settings. Other components or configurations may be used instead of the comparator 712 to compare the detected slew rate Vslew_dec and the adaptive slew rate setting Vslew_set, and generate the trigger signal Vslew_out.

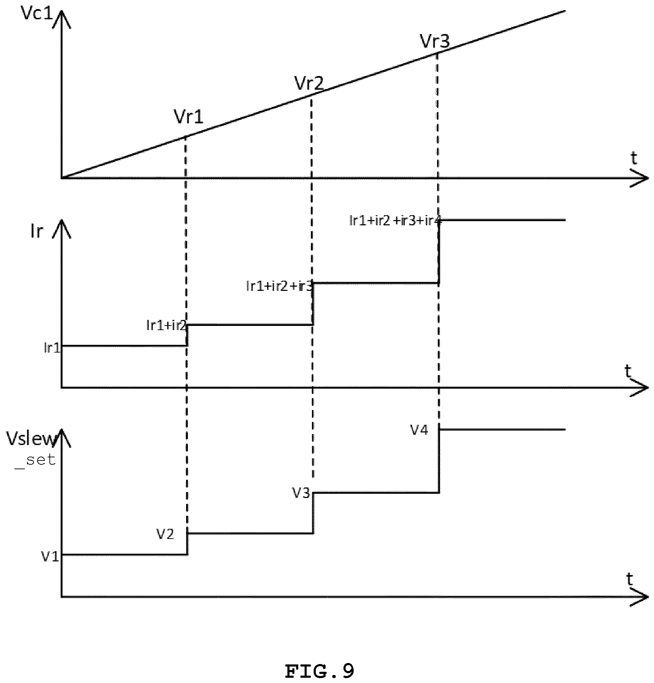

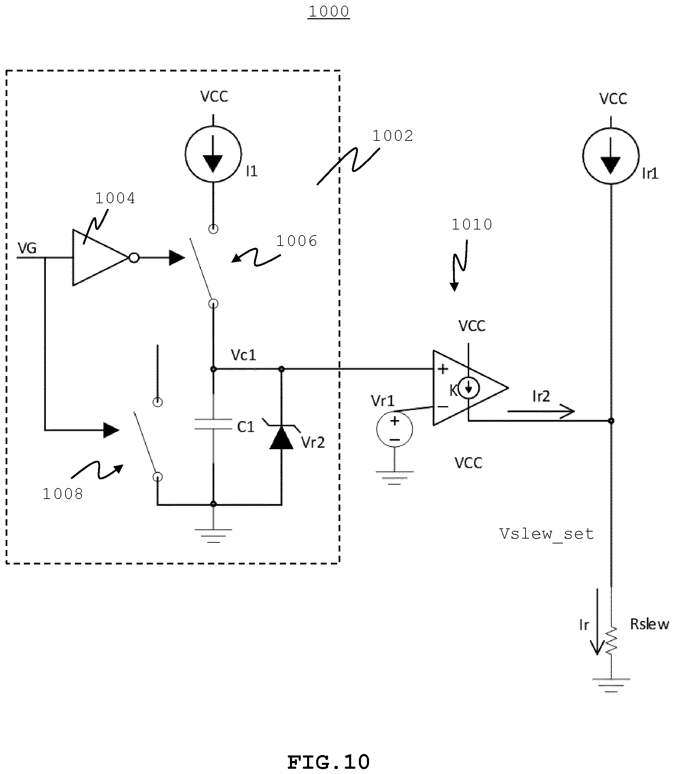

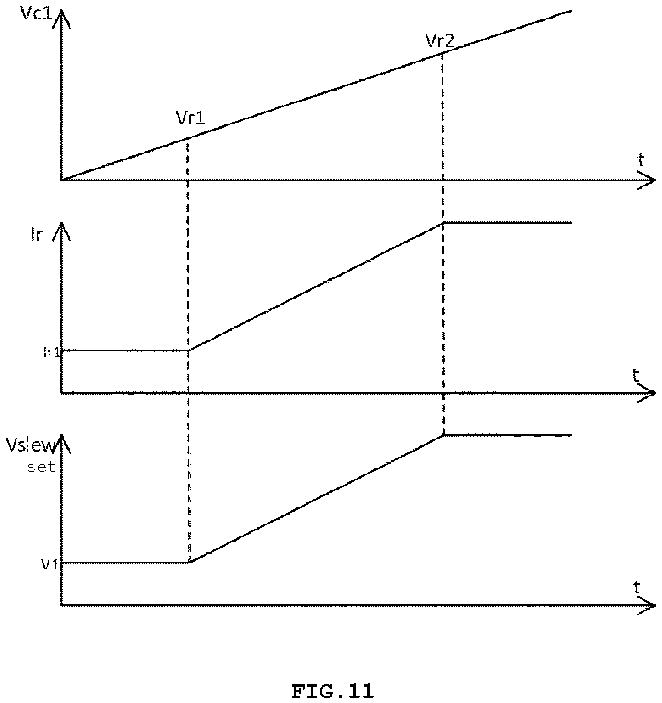

Fig. 8 and Fig. 10 show block diagrams of example embodiments of adaptive slew rate circuits 800, 1000 for determining the adaptive slew rate setting Vslew_set. The adaptive slew rate circuit 800, 1000 is typically part of the secondary controller 704. In the example embodiment of Fig. 8, the adaptive slew rate setting may be in a step mode, resulting in a slew rate setting Vslew_set as shown in the example of Fig. 9. In the example of Fig. 10, the adaptive slew rate setting may be in a continuous mode, resulting in a slew rate setting Vslew_set as shown in the example of Fig. 11.

The slew rate detection circuit, such as the circuit 800 or 1000, is typically active when the secondary switch S2 is closed, i.e., when the control signal to the gate G of the secondary switch S2 is low. In the example of Fig. 6 this corresponds to the period prior to t1 and the period between t2 and t4, where the slew rate is used to trigger turning on the secondary switch S2.

The closed state of the secondary switch S2 may be detected by a gate state detection circuit 802, 1002, such as shown in the examples of Fig. 8 and Fig. 10. When the control signal at the gate G is low, the gate voltage VG may be low, resulting in the invertor 804, 1004 generating a high signal closing the switch 806, 1006. The slew rate detection circuit 800, 1000 may then be connected to the voltage source VCC. The other switch 808, 1008 of the gate state detection circuit 802, 1002 may then be opened.

Similarly, the opened state of the secondary switch S2 may be detected by the gate state detection circuit 802, 1002. When the control signal at the gate G is high, the gate voltage VG may be high, resulting in the invertor 804, 1004 generating a low signal opening the switch 806, 1006. The slew rate detection circuit 800, 1000 may then be disconnected from the voltage source VCC. The other switch 808, 1008 of the gate state detection circuit 802, 1002 may then be closed.

When the secondary switch S2 is closed, i.e., VG is low, switch 806/1006 is closed and switch 808/1008 is opened, the capacitor C1 is charged by the current 11. As a result, the longer the off time of the secondary switch S2, the higher the voltage at Vc1.

In the example of Fig. 8, the slew rate detection circuit 800 includes a plurality of current selectors 810, each controlling a switch 812 for including a current source into the circuit 800. The current flow through slew rate resistor Rslew, depicted as slew rate current Ir, may generate the adaptive slew rate setting voltage Vslew_set, used by the secondary controller 704, such as shown in Fig. 7.

In the example of Fig. 8, the slew rate resistor Rslew may be charged by base current Ir1 at the beginning. If Vc1 is higher than Vr1, the current selector 810 at Vr1 may close the corresponding switch 812 and the current Ir2 may be added to Ir. If Vc1 is higher than Vr2, the current selector 810 at Vr2 may close its corresponding switch 812 and the current Ir3 may be added to Ir. If Vc1 is higher than Vr3, the current selector 810 at Vr3 may close its corresponding switch 812 and the current Ir4 may be added to Ir. There may be any number of step-up converts 810 to add current in steps to Ir, depending on implementation requirements.

Fig. 9 shows an example of stepping up of the current Ir as a result of adding current sources to the circuit by the current selectors 810. The top graph shows levels of voltage Vc1 in time. When Vc1 reaches Vr1, the current source Ir2 may be added to the circuit, resulting in the step-up of the current from Ir to Ir+Ir2, as shown in the middle graph of Fig. 9. When Vc1 reaches Vr2, the current source Ir3 may be added to the circuit, resulting in the further step-up of the current from Ir+lr2 to Ir+lr2+lr3. When Vc1 reaches Vr3, the current source Ir4 may be added to the circuit, resulting in the further step-up of the current from Ir+Ir2+Ir3 to Ir+Ir2+Ir3+Ir4. Corresponding slew rate setting voltages Vslew_set are shown in the bottom graph of Fig. 9.

In the example of Fig. 10, the slew rate detection circuit 1000 includes a current selector 1010 for continuously increasing an output current Ir2 depending on the voltage Vc1. The current flow through slew rate resistor Rslew, depicted as slew rate current Ir, may generate the adaptive slew rate setting voltage Vslew_set, used by the secondary controller 704, such as shown in Fig. 7.

In the example of Fig. 10, the slew rate resistor Rslew may be charged by first current source Ir1 increased with the current I2 from the current selector 1010. For example, current Ir2 may be set to zero when Vc1<Vr1 and set to (Vc1-Vr1)*K when Vr1 <Vc1 <Vr2.

Fig. 11 shows an example of continuously increasing of the current Ir as a result of adding current Ir2 to the circuit by the current selector 1010. The top graph shows levels of voltage Vc1 in time. When Vc1 reaches Vr1, the current Ir2 may be added to the circuit, which current I2 continuously increases until Vc1 reached Vr2. Corresponding slew rate setting voltages Vslew_set are shown in the bottom graph of Fig. 11.

With reference to Fig. 7, the higher Vslew_set, such as determined by the slew rate detection circuit 800 or 1000, the longer the charge time of C2 to the voltage level of Vslew_set, and thus the slower the slew rate Vslew_out. In the example of Fig, 7, the slew rate Vslew_out may be determined as 2V (i.e., the maximum value of Vds_S2 in the example of Fig. 7) divided by the charge time of C2.

The present application may advantageously be used in quick chargers and power adapters.

## Claims

1. A controller (704) of a synchronous rectifier (SR),
the synchronous rectifier (SR) comprising a switch (S2) that is switchable by the controller (704), and
the controller (704) comprising an adaptive slew rate detection circuit (800, 1000),
wherein the adaptive slew rate detection circuit (800, 1000) is configured to add a current (Ir2, Ir3, Ir4) to a base slew rate current (Ir1) depending on an off-time of the switch (S2) to obtain a slew rate current (Ir),
wherein the slew rate current (Ir) determines a slew rate setting voltage (Vslew_set),
and wherein the controller (704) is configured to turn on the switch (S2) depending on the slew rate setting voltage (Vslew_set).

2. The controller (704) according to claim 1,
further comprising a gate state detection circuit (802, 1002) configured to detect an off-state of the switch (S2),
and wherein the adaptive slew rate detection circuit (800, 1000) is configured to add the current (Ir2, Ir3, Ir4) to the base slew rate current (Ir1) when the switch (S2) is in the off-state.

3. The controller (704) according to claim 1 or claim 2,
wherein the adaptive slew rate detection circuit (800) comprises a plurality of current selectors (810),
wherein each current selector (810) is configured to detect different off-times of the switch (S2) based on a voltage (Vc1) generated as a result of charging characteristics of a capacitor (C1) during the off-time of the switch (S2);
and wherein each current selector (810) is configured to include a different current source to the adaptive slew rate detection circuit (800) to add a respective current (Ir2, Ir3, Ir4) to the base slew rate current (Ir1).

4. The controller (704) according to claim 3, wherein each current selector (810) is configured to switch a current switch (812) to include the respective current source into the slew rate detection circuit (800).

5. The controller (704) according to claim 1 or claim 2,
wherein the adaptive slew rate detection circuit (1000) comprises a current selector (1010),
and wherein the current selector (1010) is configured to increasingly add the current (Ir2) depending on the off-time of the switch (S2) based on a voltage (Vc1) generated as a result of charging characteristics of a capacitor (C1) during the off-time of the switch (S2).

6. The controller (704) according to any one of the preceding claims, wherein the synchronous rectifier (SR) is configured to operate in a discontinuous current mode, DCM.

7. The controller (704) according to any one of the preceding claims, wherein the switch (S2) comprises a field-effect transistor, FET.

8. A synchronous flyback converter comprising:
a transformer (T1),
a primary switch (S1) coupled to a primary winding of the transformer (T1), and
a synchronous rectifier (SR) coupled to a secondary winding of the transformer (T1),
wherein the synchronous rectifier (SR) comprises a secondary switch (S2) that is switchable under control of a controller (704) according to any one of the claims 1-6.

9. A switching power supply comprising a synchronous flyback converter according to claim 8.
